# EUROPEAN PATENT SPECIFICATION

(11) **EP 1 674 230 B1**
(45) Date of publication and mention of the grant of the patent: **06.11.2013**
(21) Application number: 04788238.6
(22) Date of filing: 28.09.2004
(51) Int. Cl.: B32B 27/32, B32B 27/36

(54) **MULTI-LAYER SHEET**
MEHRLAGIGE FOLIE
FEUILLE MULTICOUCHE

(30) Priority: 30.09.2003 JP 2003342194
(43) Date of publication of application: 28.06.2006
(73) Proprietor: SEKISUI CHEMICAL CO., LTD., Osaka-shi, Osaka 530-8565 (JP)
(72) Inventor: MATSUMOTO, Hirotake, Sekisui Chemical Co., Ltd., Mishima-gun, Osaka 618-8589 (JP)
(74) Representative: Merkle, Gebhard
(86) International application number: PCT/JP2004/014171
(87) International publication number: WO 2005/030466

(56) References cited:
- JP-A- 2 024 139
- JP-A- 2 175 247
- JP-A- 2000 345 125
- JP-A- 2004 002 593
- JP-A- 2004 002 593
- JP-A- 2004 002 789
- JP-A- 2004 002 789
- US-A- 5 080 979

## Description

### TECHNICAL FIELD

The present invention relates to a multi-layer sheet which is excellent in heat resistance, releasability and staining resistance and/or excellent in following-up property to an irregular surface, and can also be easily disposed of after the sheet is used.

### BACKGROUND ART

In the process for producing a printed circuit board, a flexible printed circuit board, a multi-layer printed circuit board or the like, a releasing sheet is used at the time of hot-pressing a copper-clad laminated sheet or a copper foil through an interposed prepreg or heat resistant film is interposed. In the process for producing a flexible printed board, at the time of hot-pressing and bonding a cover-lay film onto the body of the flexible printed board, wherein electric circuits are formed, with a thermosetting adhesive agent, the method using a releasing sheet is widely performed in order to prevent the cover-lay film from being bonded to the press hot plate.

The releasing sheet is required to follow up irregularities in the surface of a board. In the case that the sheet is used to produce a flexible printed board, the sheet is required to prevent a matter that a thermosetting adhesive agent is forced out from between a cover-lay film and the body of the flexible board, thereby staining the board.
Meanwhile, Japanese Patent Application Laid-Open No. 2-175247 discloses a releasing sheet made of a laminate wherein a soft polyolefin layer is used as an intermediate layer and crystalline polymethylpentene layers are formed on its inside and outside faces. Japanese Patent Application Laid-Open No. 2-24139 discloses a releasing multi-layer film for a print circuit laminating step wherein an intermediate layer is made of a copolymer resin made from ethylene and methyl methacrylate and upper and lower layers, between which the intermediate layer is sandwiched, are made of polypropylene or polymethylpentene. These releasing sheets are each a sheet wherein an intermediate layer made of a resin having a low softening resin is sandwiched between layers excellent in releasability, thereby making its following-up property to a board surface and its releasability compatible with each other.

However, these releasing sheets have a problem that the resin which constitutes the intermediate layer, the softening temperature of the resin being low, is forced out at the time of hot-press so that the resin stains the board or press hot plate. On the other hand, polymethylpentene or polypropylene used as a releasing layer is excellent in releasability but has a problem that at the time of hot press the resin or low molecular weight products originating from additives contained therein are shifted to the board so as to stain, in particular, circuits thereon, which is made of copper or the like and thus it is feared that the quality thereof is unsatisfactory for instruments used in the field of communication, for which a high quality is required, or others.

Hitherto, a fluorine-containing sheet as disclosed in, for example, Japanese Patent Application Laid-Open No. 5-283862 has also been used as a sheet excellent in releasability in many cases. However, the fluorine-containing sheet is expensive and further has problems that the sheet is not easily burned up and generates poisonous gas in waste incinerating disposal after the use of the sheet although the sheet is excellent in heat resistance, releasability and stain resistance. Thus, the sheet does not sufficiently meet social requests about environmental problems and safety.
Japanese Patent Application Laid-Open No. 1-229045 discloses a releasing sheet wherein stain resistance is improved by applying a mixture of a higher alcohol or the like, a zirconium compound and a titanium compound onto a surface of a polyester sheet. However, even if such a surface treatment is conducted, the resistance thereof against stains onto a partner member is not yet sufficient under conditions for hot press or the like.

Meanwhile, Japanese Patent No. 2659404 discloses a multi-layer film, for releasing, wherein an intermediate layer is made of a copolymer resin made from ethylene and methyl methacrylate and resin layers made of polypropylene or polymethylpentene are laminated on and beneath the intermediate layer. This releasing multi-layer film is used as a releasing film when a flexible printed circuit board is produced. It is stated therein that the shape-following-up property thereof is made high by use of the copolymer resin composition comprising ethylene and methyl methacrylate as the intermediate layer and further the releasability thereof are made high since the layers on both sides is made of polypropylene or polymethylpentene. It is also stated that the above-mentioned adhesive agent exudation gets less in hot press at the time of producing a printed circuit board.

Similarly, Japanese Patent Application Laid-Open No. 2003-246019 discloses a releasing film used in a method for producing a flexible wiring board. In this releasing film, the following are laminated: a releasing layer made of polymethylpentene or a copolymer of polymethylpentene and an α-olefin and a releasing opposite-side layer made of a copolymer selected from an α-olefin copolymer, an acrylic acid ester copolymer and other copolymers. The melt flow rate of the resin of the releasing opposite-side layer and the melting point thereof are set into the range of 0.3 to 10.0 g/L and that of 50 to 150°C, respectively, and the Rockwell hardness of the resin constituting the releasing layer and the thickness thereof are set into the range of 65 to 88 and that of 10 to 100 µm, respectively. The film further has a structure wherein an adhesive resin layer is interposed between the releasing layer and the releasing opposite-side layer. About this releasing film also, it is stated that when this film is used as a releasing film in the process for producing a flexible printed circuit board, the releasability and shape-following-up property are made high.

However, according to the structures described in Japanese Patent No. 2659404 and Japanese Patent Application Laid-Open No. 2003-246019, the shape-following-up property is not yet sufficient in the case of using the structure as a releasing sheet when many flexible printed boards are laminated and then the resultant is hot-pressed at a time by a hot press method. For this reason, there is a problem that, for example, in a flexible printed circuit board, an adhesive agent is forced out onto electrode lands which are electrode portions made of Cu or the like and are made naked for electric connection to the outside so that the reliability of the electric connection is damaged.

Patent document 1: Japanese Patent Application Laid-Open No. 2-175247
Patent document 2: Japanese Patent Application Laid-Open No. 2-24139
Patent document 3: Japanese Patent Application Laid-Open No. 5-283862
Patent document 4: Japanese Patent Application Laid-Open No. 1-229045
Patent document 5: Japanese Patent No. 2659404
Patent document 6: Japanese Patent Application Laid-Open No. 2003-246019
US 5 080 979 discloses a multilayer release film for the production of printed circuit (boards).

### DISCLOSURE OF THE INVENTION

In light of the above-mentioned present situation, an object of the present invention is to provide a multi-layer sheet which is excellent in heat resistance, releasability and staining resistance, and can also be easily disposed of after the sheet is used.
Another object of the present invention is to provide a multi-layer sheet which is excellent in following-up property to an irregular surface, is excellent in resistance against the forcing-out of the constituents thereof, and can also be easily disposed of after the sheet is used.

According to a broad aspect of the present invention, provided is a multi-layer sheet as defined in claim 1.
In a specific aspect of the multi-layer sheet according to the present invention, calling the resin having a melting point in the range of 50 to 130°C a first resin, the following-up layer further comprises a second resin having a melting point higher than 130°C and not higher than 250°C besides the first resin.

In another specific aspect of the multi-layer sheet according to the present invention, the following-up layer has a complex viscosity of 1000 to 10000 Pa·s at 170°C and a tan δ of less than 1 at 170°C.
In the invention, the multi-layer sheet may have various laminate structures as long as the following-up layer and the releasing layer are laminated on each other. For example, a second releasing layer may be laminated on a face of the following-up layer which is opposite to the following-up layer face on which the releasing layer is laminated. In this case, the second releasing layer comprises a resin composition including mainly a resin having a melting point of 200°C or higher.

In the present invention, a sheet means not only a sheet but also a film. The present invention will be described in detail hereinafter.

The multi-layer sheet of the present invention has at least a following-up layer and a releasing layer. The following-up layer is a layer for securing following-up property to irregularities in a board surface, and the releasing layer is a layer for securing releasability from a board or press hot plate. The following-up layer which constitutes the multi-layer sheet of the invention is made mainly of at least one resin having a melting point of 50 to 130°C. Calling this resin, which has a melting point of 50 to 130°C, a first resin, the following-up layer preferably comprises a second resin having a melting point higher than 130°C and not higher than 250°C besides the first resin. The first and second resins each need to have a melting point of 250°C or lower. The melting point of the first resin is in the range of 50 to 130°C and that of the second resin is higher than 130°C and not higher than 250°C. In the instant specification, the melting point of a resin means the melting peak temperature of the resin measured by DSC.

If the melting points of the first and second resins in the following-up layer are higher than 250°C in the invention, the shape-following-up property of the following-up layer cannot be made higher than that of the releasing layer. When the melting point of the first resin, which is one of the resins, is from 50 to 130°C and the melting point of the second resin is set to higher than 130°C, the first resin secures a sufficient shape-following-up property and the second resin restrains the resins from being forced out at the time of hot press. If at least one of the resins is not in the range of 50 to 130°C, a sufficient shape-following-up property cannot be obtained. If the melting point of the second resin is lower than 130°C, it is feared that the resin which gives following-up property at the time of hot press is forced out.
The first and second resins are incompatible with each other.

Combinations of the first and second resins may be the following resins. That is, examples of the first resin having a melting point of 50 to 130°C include an α-olefin such as ethylene, propylene, butene, pentene, hexene, octene, or methylpentene, or copolymers made from two or more thereof; and copolymers made from one or more α-olefins, such as ethylene, and one or more compounds selected from vinyl acetate, acrylic acid, methacrylic acid, acrylic acid ester, methacrylic acid ester, maleic acid, maleic anhydride, norbornene, ethylidenenorbornene and others. The first resin may be polyethylene resin, ethylene-vinyl acetate copolymer, ethylene-acrylate copolymer resin, ethylene-methyl acrylate copolymer resin, ethylene-ethyl acrylate copolymer resin, ethylene-butyl acrylate copolymer resin, or the like. Examples of the second resin having a melting point higher than 130°C and not higher than 250°C include polypropylene based resin, (1-)butene based resin, polypentene based resin, polymethylpentene based resin, polyesters such as polybutylene terephthalate, polypropylene terephthalate and polyethylene terephthalate, polyamides such as 6-nylon (registered trade mark), 11-nylon (registered trade mark) and 12-nylon (registered trade mark), polycarbonate, and modified compounds thereof.
The blend ratio between the first and second resins is not particularly limited, and the ratio of the second resin is desirably from 5 to 100 parts by weight, more preferably from 10 to 50 parts by weight based on 100 parts by weight of the first resin. If the blend ratio of the second resin is less than 5 parts by weight, the following-up layer may not be restrained from being forced out at the time of hot press. If the ratio is more than 100 parts by weight, the shape-following-up property may become low.

Preferably, the lower limit of the complex viscosity of the following-up layer is 1000 Pa·s at 170°C, and the upper limit thereof is 10000 Pa·s at 170°C. If the viscosity is less than 1000 Pa·s, the resin constituting the following-up layer may be forced out at the time of hot press so that the resin may stain the press hot plate or the like. If the viscosity is more than 10000 Pa·s, the thermosetting resin adhesive agent may not be sufficiently restrained from being forced out from the cover-lay film. More preferably, the lower limit is 3000 Pa·s and the upper limit is 8000 Pa·s.

The lower limit of the complex viscosity of the following-up layer is preferably 100 Pa·s at 250°C, and the upper limit thereof is preferably 5000 Pa·s at 250°C. If the viscosity is less than 100 Pa·s, the viscosity is too low so that the moldability may be poor. If the viscosity is more than 5000 Pa·s, at the time of producing the layer by a multi-layer co-extrusion method an interface between the layer and the other layer easily gets rough so that the quality of the external appearance may be damaged. More preferably, the lower limit is 500 Pa·s and the upper limit is 3000 Pa·s.

The tan δ of the following-up layer is preferably less than 1 at 170°C. If the tan δ is more than 1, the resin constituting the following-up layer may be forced out at the time of hot press so that the resin may stain the press hot plate or the like. The tan δ is more preferably less than 0.9.

The tan δ of the following-up layer is preferably 1.5 or more at 250°C. If the tan δ is less than 1.5, at the time of producing the layer by a multi-layer co-extrusion method an interface between the layer and the other layer easily gets rough so that the quality of the external appearance may be damaged. More preferably, the tan δ is 1.8 or more.

In the present specification, the complex viscosity and the tan δ mean those measured by use of a parallel plate of 25 mm diameter as a tool under conditions of a frequency of 10 rad/second, a strain of 10% and temperatures of 170°C and 250°C, and can be measured by use of an RMS-800 manufactured by Rheometric Co., or the like.

Such a following-up layer wherein the complex viscosity and the tan δ are compatible with each other is not particularly limited. The inventors have made eager investigations to find that the above-mentioned complex viscosity and the tan δ can easily be expressed when a resin composition comprising two or more resins is used to form the following-up layer in such a manner that the two or more resins form a phase separation structure.
The phase separation structure is a sea-island structure since this structure produces only a small effect on the softening property of each of the resins. The sea-island structure comprises at least the first and second resins which are incompatible with each other. For the selection of the resins constituting the sea-island structure, it is preferred that the melting point of the second resin constituting the islands is higher than that of the first resin constituting the sea. If the melting point of the second resin constituting the islands is lower than that of the first resin constituting the sea, the effect of restraining the resins from being forced out at the time of hot press may lower.

The first resin constituting the sea of the above-mentioned following-up layer, which has a sea-island structure, is not particularly limited. The lower limit of the melting point thereof is preferably 50°C, and the upper limit thereof is preferably 130°C. If the melting point is lower than 50°C, the multi-layer sheets are melted and bonded to each other when they are stored or transported. Consequently, the multi-layer sheets may be unpractical. If the melting point is more than 130°C, an effect of restraining the thermosetting adhesive agent from being forced out from the cover-lay film may not be obtained. The lower limit is more preferably 80°C and the upper limit is more preferably 120°C.
Examples of the resin which can be used as such a resin include an α-olefin such as ethylene, propylene, butene, pentene, hexene, octene, or methylpentene, or copolymers made from two or more thereof; and copolymers made from one or more α-olefins, such as ethylene, and one or more compounds selected from vinyl acetate, acrylic acid, methacrylic acid, acrylic acid ester, methacrylic acid ester, maleic acid, maleic anhydride, norbornene, ethylidenenorbornene and others. The resin may be polyethylene resin, ethylene-vinyl acetate copolymer, ethylene-acrylate copolymer resin, ethylene-methyl acrylate copolymer resin, ethylene ethyl acrylate copolymer resin, ethylene-butyl acrylate copolymer resin, or the like. These resins may be used alone or in combination of two or more thereof.

The second resin constituting the islands of the above-mentioned following-up layer, which has a sea-island structure, is not particularly limited if this resin is a resin incompatible with the resin constituting the sea. The lower limit of the melting point thereof is preferably 130°C. If the melting point is lower than 130°C, an effect of restraining the following-up layer from being forced out at the time of hot press may not be obtained. The lower limit is more preferably 200°C. Example of the second resin having a melting point higher than 130°C and not higher than 250°C include high-density polyethylene, polypropylene and poly(1-)butene. Examples of the resin having a melting point of 200°C or higher include polymethylpentene, polyester resins such as polybutylene terephthalate, polyamides such as 11-nylon (registered trade mark), 12-nylon (registered trade mark) and6-nylon (registered trade mark), polycarbonate, and modified compounds thereof.
As an example of the combination of these resins, the first resin and the second resin are low-density polyethylene and polybutylene terephthalate, respectively, ethylene ethyl acrylate and polybutylene terephthalate, respectively, or ethylene vinyl acetate copolymer and 6-nylon (registered trade mark), respectively.
The above-mentioned following-up layer has a sea-island structure and, about the blend ratio between the first resin constituting the sea and the second resin constituting the islands, the ratio of the resin constituting the islands is desirably from 5 to 100 parts by weight, more preferably from 10 to 50 parts by weight based on 100 parts by weight of the resin constituting the sea. If the blend ratio of the resin constituting the islands is less than 5 parts by weight, the resins may not restrained from being forced out at the time of hot press. If the blend ratio is more than 100 parts by weight, the shape-following-up property may not be sufficient. The multi-layer sheet may comprises, besides the first and second resins, one or more different resins.

The above-mentioned releasing layer comprises a resin composition including mainly a resin having a melting point of 200°C or higher. If the melting point of the resin as the main component is lower than 200°C, the layer cannot express heat resistance against hot press so that the releasability lowers. Preferably, the melting point is 220°C or higher.
In the present invention, the releasing layer and the second releasing layer which is added at will have the same structure or different structures. When the releasing layers of any two out of the multi-layer sheets according to the present invention are pressed and bonded onto each other under a condition of 170°C and 3 MPa for 30 minutes, it is preferred that the releasing layers exhibit a blocking force of 0.1 N/cm or less, the blocking force being measured in accordance with ASTM D1893. If the blocking force is more than 0.1 N/cm, the releasability is insufficient. Accordingly, in the case of using a process for producing a product wherein a plurality of the multi-layer sheets of the present invention are laminated, it may be difficult that the multi-layer sheets are finally peeled from each other without any compulsion. The blocking force is more preferably 0.02 N/cm or less.

The resin which constitutes the above-mentioned resin composition, the melting point of the resin being 200°C or higher, has a polar group. When the releasing layer comprises the resin composition including mainly the resin having a polar group, the releasing layer becomes a layer excellent in mechanical properties. The resin having a polar group has the polar group in the main chain thereof. By use of the resin having a polar group in the main chain thereof, the resultant multi-layer sheet of the present invention becomes a multi-layer sheet more satisfactory in mechanical properties. The wording "having a polar group" in the present specification means that an ester, amido, imide, ether, thioether, carbonyl, hydroxyl, amino or carboxyl group or some other group constitutes a portion of the resin.

The above-mentioned resin having a polar group is a crystalline aromatic polyester. Crystalline aromatic polyester having a polar group in the main chain thereof is used for the following reason: when this polyester is subjected to incinerating treatment, environment load is decreased since the polyester does not contain any heteroatom in the molecule thereof; therefore, it is also economically profitable.

The crystalline aromatic polyester can be yielded by causing an aromatic dicarboxylic acid or an ester-producing derivative thereof to react with a low molecular weight aliphatic diol or a high molecular weight diol. Examples of the aromatic dicarboxylic acid or ester-producing derivative thereof include terephthalic acid, isophthalic acid, orthophthalic acid, naphthalenedicarboxylic acid, paraphenylenedicarboxylic acid, dimethyl terephthalate, dimethyl isophthalate, dimethyl orthophthalate, dimethyl naphthalenedicarboxylate, and dimethyl paraphenylenedicarboxylate. These may be used alone or in combination of two or more thereof.

Examples of the low molecular weight aliphatic diol include ethylene glycol, 1,2-propanediol, 1,3-propanediol, 1,3-butanediol, 1,4-butanediol, neopentyl glycol, 1,5-pentanediol, 1,6-hexanediol, and 1,4-cyclohexanedimethanol. These may be used alone or in combination of two or more thereof.

Examples of the high molecular weight diol include polyethylene glycol, polypropylene glycol, polytetramethylene glycol, and polyhexamethylene glycol. These may be used alone or in combination of two or more thereof.

Examples of the crystalline aromatic polyester made from the above-mentioned components include polyethylene terephthalate, polybutylene terephthalate, polyhexamethylene terephthalate, polyethylene naphthalate, polybutylene naphthalate, and butanediol terephthalate polytetramethylene glycol copolymer. These may be used alone or in combination of two or more thereof. Of these, aromatic polyester containing at least butylene terephthalate as a crystalline component is preferred. When the butylene terephthalate component is contained, the resultant releasing layer is excellent in stain resistance and crystallinity.

The multi-layer sheet of the present invention preferably has a crystal melting heat quantity of 40 J/g or more. If the quantity is less than 40 J/g, the sheet may not express heat resistance against hot press molding. Moreover, the dimensional change rate at 170°C also becomes large; accordingly, at the time of hot press molding, the circuit pattern may be damaged. The quantity is more preferably 50 J/g or more. In the case that the crystalline aromatic polyester in the releasing layer contains a butylene terephthalate component as a crystalline component, the crystal melting heat quantity is more preferably 40 J/g or more.
In order to improve the crystallinity to make the crystal melting heat quantity high, an additive for promoting crystallization, such as a crystal nucleus agent, may be added to the above-mentioned resin composition. The cooling temperature at the time of melt-molding the multi-layer sheet is set preferably to a temperature not lower than the glass transition temperature of the aromatic polyester, more preferably to a temperature of 70 to 150°C. The crystal melting heat quantity can be measured by differential scanning calorimetry (DSC).

The surface of the releasing layer preferably has smoothness. It is allowable to give thereto slipping property, anti-blocking property or the like necessary for handling. An appropriate embossment pattern may be given to at least one of the faces thereof in order to remove air at time of hot press molding.

The releasing layer is preferably subjected to heat treatment in order to improve the heat resistance and the dimensional stability thereof, in particular, the releasability. In the case of producing the releasing layer by a melt molding method, at the time when the raw materials thereof are discharged in a melt state from a T-die and then cooled and fixed with a cooling roll, incomplete crystal, which is not sufficiently crystallized, may remain on the surface of the releasing layer. When such incomplete crystal is present on the surface of the releasing layer, it appears that the releasability is poor since surface molecules in the releasing layer keep high molecular mobility. When the releasing layer is subjected to heat treatment to crystallize the incomplete crystal, the molecular mobility of the surface molecules in the releasing layer is suppressed so that the releasability can be improved.

The method for the heat treatment is not particularly limited. For example, a method of passing the multi-layer sheet between rolls heated to a constant treatment temperature is preferred since the multi-layer sheet can be treated in steps continuous from the melt molding method.
The temperature for the heat treatment is not particularly limited if the temperature is a temperature higher than the glass transition temperature of the resin constituting the releasing layer and not higher than the melting point thereof. The lower limit thereof is preferably 120°C and the upper limit is preferably 200°C. If the temperature is lower than 120°C, the releasability-improving effect based on the heat treatment is hardly obtained. If the temperature is higher than 200°C, the releasing layer deforms easily and thus the layer may not be produced. The lower limit is more preferably 170°C and the upper limit is more preferably 190°C.

It is effective for an improvement in the releasability of the releasing layer to subject the releasing layer to rubbing treatment. By the rubbing treatment, the above-mentioned incomplete crystal is recrystallized by frictional energy so that strong crystal is formed. Therefore, the crystal would suppress the molecular mobility of surface molecules in the releasing layer so that the releasability can be improved.

The method for the above-mentioned rubbing treatment is not particularly limited, and an example thereof is a method of rubbing the surface of the releasing layer with a rotating member such as a metal roll, or cloth such as gauze. The direction of the rubbing in the rubbing treatment is not particularly limited. The direction may be parallel or perpendicular to the longitudinal direction of the releasing layer. It is preferred to rub the releasing layer surface at a rate of 30 m/minute or more by use of, for example, a piece of cloth or a brush.
Since the purpose of the rubbing treatment is the crystallization of the above-mentioned surface molecules, it is unnecessary to apply such rubbing that the surface roughness of the releasing layer changes before and after the rubbing treatment.

The releasing layer can exhibit very good mechanical properties since the layer has the above-mentioned structure. In other words, when two releasing layers out of a plurality of the releasing layers are pressed and bonded onto each other under a condition of 170°C and 3 MPa for 30 minutes, the releasing layers exhibit a blocking force of 0.02 N/cm or less, the blocking force being measured in accordance with ASTM D1893. At 170°C, at which hot press is ordinarily performed, the storage elastic modulus is from 20 to 200 MPa, the 100% elongation load is from 49 to 490 mN/mm, the tensile fracture elongation is 500% or more, and further the dimension change rate is 1.5% or less when the releasing layer is pressed at a load of 3 MPa and 170°C for 60 minutes. Since such mechanical properties can be exhibited, the releasing film of the present invention is very suitable as a releasing film used in the process for producing a printed circuit board, a flexible printed circuit board or a multi-layer printed circuit board.

If the blocking force measured in accordance with ASTM D1893 when the releasing layers are pressed and bonded to each other under a condition of 170°C and 3 MPa for 30 minutes is more than 0.02 N/cm, the following is caused: when the releasing film of the present invention is used as a releasing film in the process for producing a printed circuit board, a flexible printed circuit board or a multi-layer printed circuit board, the peeling resistance when the releasing film is peeled after hot press becomes large so that workability deteriorate or, in some case, the circuit is damaged.
As described above, a good reliability can be remarkably expressed, in particular, when the releasing layer is subjected to heat treatment or rubbing treatment.

When the releasing layer is overlapped with polyimide and/or metal foil and the resultant is pressed at 170°C and 3 MPa for 60 minutes, the releasing layer has high reliability from the polyimide and/or metal foil. The wording "has releasability" means that after the pressing treatment, the releasing force generated between the polyimide and/or metal foil and a sheet or film is low and thus the polyimide and/or metal foil or the sheet or film is/are not broken when the sheet or film is peeled.

The above-mentioned crystalline aromatic polyester preferably comprises a polyester having in the main chain thereof a polyether skeleton. Such a polyester is obtained by causing an aromatic dicarboxylic acid or an ester-forming derivative thereof to react with a low molecular weight aliphatic diol and a high molecular weight diol.
About the resin composition containing such a crystalline aromatic polyester, flexibility can be obtained while heat resistance and releasability are kept by dispersing a crystalline aromatic polyester containing a high molecular weight diol component finely into a matrix comprising a crystalline aromatic polyester containing no high molecular weight diol.

The above-mentioned polyester, which has in the main chain thereof a polyether skeleton, preferably has a melting point of 170°C or higher. If the melting point is lower than 170°C, the resultant multi-layer sheet may be poor in releasability when the sheet is used as a releasing sheet. Such a polyester having in the main chain thereof a polyether skeleton is not particularly limited, and examples thereof include butanediol terephthalate polytetramethylene glycol copolymer and butanediol terephthalate polypropylene glycol copolymer.

The content of the above-mentioned polyester, which has in the main chain thereof a polyether skeleton, in the crystalline aromatic polyester is preferably 50% or less by weight. If the content is more than 50% by weight, the resultant sheet may not easily be peeled when the sheet is used as a releasing sheet.

The halogen content in the resin composition constituting the releasing layer is preferably 5% or less by weight. According to this, toxic materials containing a halogen are not generated even if the multi-layer sheet is incinerated. The halogen content is preferably 3% or less by weight, more preferably 1% or less by weight. If the halogen content is less than 1% by weight, the approval of substantial non-halogen material in Europe can be obtained.

The resin composition constituting the releasing layer may contain a stabilizer as long as staining resistance does not become a problem. Examples of the stabilizer include hindered phenol antioxidants such as 1,3,5-trimethyl-2,4,6-tris(3,5-di-t-butyl-4-hydroxybenzyl)b enzene, 3,9-bis{2-[3-(3-t-butyl-4-hydroxy-5-methylphenyl)-propionyl oxy]-1,1-dimethylethyl}-2,4,8,10-tetraoxaspiro[5,5]undecane ; and thermal stabilizers such as tris(2,4-di-t-butylphenyl)phosphite, trilaurylphosphite, 2-t-butyl-α-(3-t-butyl-4-hydroxyphenyl)-p-cumenylbis (p-nonylphenyl) phosphite, dimyristyl 3,3'-thiodipropionate, distearyl 3,3'-thiodipropionate, pentaerystyryltetrakis(3-laurylthiopropionate) and ditridecyl 3,3'-thiodipropionate.

The resin composition constituting the releasing layer may contain additives such as a fiber, an inorganic filler, a flame retardant, an ultraviolet absorbent, an antistatic agent, an inorganic material, and a higher fatty acid salt as long as the practicability is not damaged.

Examples of the fiber include inorganic fibers such as glass fiber, carbon fiber, boron fiber, silicon carbide fiber, alumina fiber, amorphous fiber and silicon/titanium/carbon based fiber; and organic fibers such as aramide fiber. Examples of the inorganic filler include calcium carbonate, titanium oxide, mica, and talc. Examples of the flame retardant include hexabromocyclododecane, tris-(2,3-dichloropropyl)phosphate, and pentabromophenyl allyl ether.

Examples of the ultraviolet absorbent include p-t-butylphenyl salicylate, 2-hydroxy-4-methoxybenzophenone, 2-hydroxy-4-methoxy-2'-carboxybenzophenone, and 2,4,5-trihydroxybutyrophenone. Examples of the antistatic agent include N,N-bis(hydroxyethyl)alkylamine, alkylallylsulfonate, and alkylsulfanate. Examples of the inorganic material include barium sulfate, alumina, and silicon oxide. Examples of the higher fatty acid salt include sodium stearate, barium stearate and sodium palmitate.

The resin composition constituting the releasing layer may contain a thermoplastic resin or a rubber component in order to modify the nature thereof. Examples of the thermoplastic resin include polyolefin, modified polyolefin, polystyrene, polyamide, polycarbonate, polysulfone, and polyester. Examples of the rubber component include natural rubber, styrene-butadiene copolymer, polybutadiene, polyisoprene, acrylonitrile-butadiene copolymer, ethylene-propylene copolymer (EPM or EPDM), butyl rubber, acrylic rubber, silicon rubber, urethane rubber, olefin-based thermoplastic elastomer, styrene-based thermoplastic elastomer, vinyl chloride-based thermoplastic elastomer, ester-based thermoplastic elastomer, and amide-based thermoplastic elastomer.

The resin composition constituting the releasing layer preferably contains an inorganic compound having a large aspect ratio. When the composition contains the inorganic compound, which has a large aspect ratio, the releasability of the multi-layer sheet of the invention at high temperatures can be improved. Furthermore, the additives or low molecular weight components are restrained from being bled out to the surface, whereby cleanliness can be improved at the time of hot press molding.
Examples of the inorganic compound include lamellar silicates such as clay, and lamellar bihydrates such as hydrotalcite.

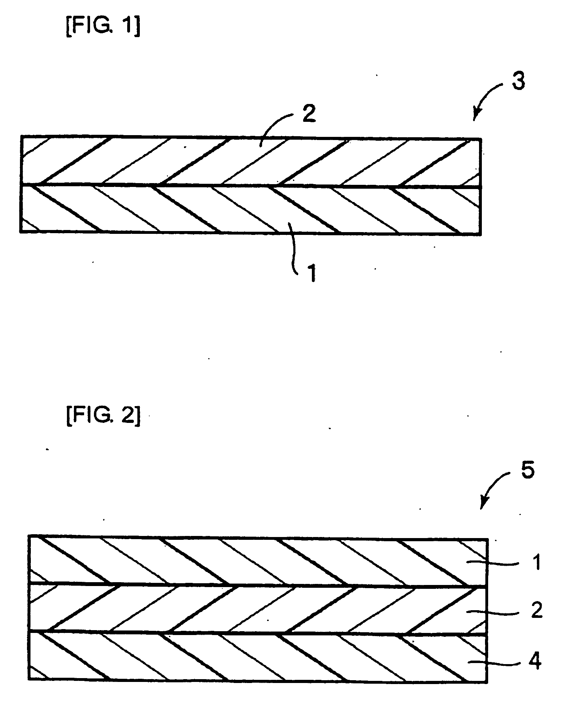

As illustrated in a schematic, front sectional view as Fig. 1, the multi-layer sheet of the present invention may be a multi-layer sheet 3 composed of a releasing layer 1 and a shape following-up layer 2. As illustrated in a front sectional view as Fig. 2, the multi-layer sheet may be a multi-layer sheet 5 having a three-layer structure wherein a second releasing layer 4 is laminated on a face of a following-up layer 2 opposite to the following-up layer face on which a releasing layer 1 is laminated. The case of the three-layer structure is preferable since excellent following-up property to irregularities of a board surface and excellent releasability from both faces of the board and a press hot plate can be obtained. The multi-layer sheet of the invention may have a laminated structure having four or more layers, or may have any other layer than the following-up layer and the releasing layers.

The lower limit of the thickness of the following-up layer is preferably 50 µm, and the upper limit thereof is preferably 300 µm. If the thickness is less than 50 µm, the following-up property to irregularities may become insufficient. If the thickness is more than 300 µm, the thermal conductivity at the time of hot press molding may deteriorate.
The lower limit of the thickness of the releasing layer is preferably 5 µm, and the upper limit thereof is preferably 100 µm. If the thickness is less than 5 µm, sufficient releasability is not expressed. If the thickness is more than 100 µm, the following-up effect based on the following-up layer is hindered by the releasing layer so that a sufficient following-up property may not be obtained.

The method for producing the multi-layer sheet of the invention is not particularly limited. Examples thereof include a method of forming films by a water-cooling or air-cooling co-extrusion inflation method or a co-extrusion T-die method; a method of laminating the resin composition constituting the following-up layer onto the releasing layer by an extrusion laminating method; and a method of dry-laminating the releasing layer and the following-up layer which are separately prepared. Of these, the method of forming films by a co-extrusion T-die method is preferred since the controllability of the thickness of each of the layers is excellent.

The multi-layer sheet of the invention is excellent in flexibility at high temperature, heat resistance, releasability and stain resistance. The sheet can easily disposed of at safety, and/or the sheet is excellent in following-up property to an irregular face and the property that constituents thereof are not forced out. Furthermore, the sheet is easily disposed of after the use thereof. Accordingly, when a copper-clad laminated board or copper foil is hot-pressed through an interposed prepreg or heat resistant film in the process for producing a printed circuit board, a flexible printed circuit board, a multi-layer printed circuit board or the like, the multi-layer sheet of the invention is used suitably as a releasing sheet for preventing bonding between a press hot plate and the printed circuit board, flexible printed circuit board, multi-layer printed circuit board or the like. Moreover, when a cover-lay film or cover-lay films is/are bonded through a thermosetting adhesive agent by hot press molding in the process for producing a flexible printed circuit board, the multi-layer sheet of the invention is used suitably as a releasing sheet for preventing bonding between the cover-lay film and the hot press plate or between the cover-lay films.

According to the present invention, it is possible to provide a multi-layer sheet which is excellent in heat resistance, releasability and following-up property to an irregular face, is hardly forced out at the time of hot press to exhibit excellent stain resistance, and is easily disposed of after the use thereof.

### BRIEF DESCRIPTION OF THE DRAWINGS

Fig. 1 is a schematic, front sectional view illustrating an embodiment of the multi-layer sheet of the present invention.
Fig. 2 is a schematic, front sectional view for explaining a multi-layer sheet of another embodiment of the invention.

### Explanation of reference numbers

- 1: releasing layer
- 2: following-up layer
- 3: multi-layer sheet
- 4: releasing layer
- 5: multi-layer sheet

### BEST MODES FOR CARRYING OUT THE INVENTION

The present invention will be described in more detail by way of the following examples. However, the present invention is not limited only to the examples.

### (Example 1)

A three-layer co-extruder was used to produce a multi-layer sheet having a three-layer structure wherein the following three layers were laminated in order that the layers will be described: a layer, 25 µm in thickness, made of Hytrel 2751 (manufactured by Du Pont-Toray Co., Ltd., a resin composition comprising mainly a polyester having a halogen content of 0% by weight and a glass transition temperature of 53°C and a polyester containing in the main chain thereof ether groups as polar groups); a following-up layer, 100 µm in thickness, made of EMMA (methyl methacrylate resin containing a polar group, trade mark: Acrift WH102, manufactured by Sumitomo Chemical Co., Ltd.); and a layer, 25 µm in thickness, made of the same Hytrel 2751 as described above. Separately, an extruder was used to produce a 100-µm sheet made of the same EMMA as a sheet for evaluating the following-up layer.

### (Example 2)

In the same way as in Example 1, a multi-layer sheet having a three-layer structure was produced, and then the multi-layer sheet was passed between two rolls, 300 mm in diameter, heated to 175°C at a rate of 10 m/minute, thereby subjecting the sheet to heat treatment to produce a multi-layer sheet of Example 2.

### (Example 3)

In the same way as in Example 1, a multi-layer sheet having a three-layer structure was produced, and then the sheet was subjected to a rubbing treatment by bringing the sheet into contact with a roll wherein a piece of gauze was wound around the outside surface made of the above-mentioned Hytrel 2751, the roll being rotated at a peripheral speed of 90 m/minute in the direction reversal to the direction in which the sheet was carried, thereby yielding a multi-layer sheet of Example 3.

### (Example 4)

A multi-layer sheet was yielded in the same way as in Example 2 except that the material of the central following-up layer was changed from EMMA to a low density polyethylene (abbreviated to LDPE in Table 1. Petrocene 173R, manufactured by Tosoh Corp.).

### (Example 5)

A multi-layer sheet of Example 5 was yielded in the same way as in Example 2 except that the material of the central following-up layer was changed from EMMA to a composition comprising 70 parts by weight of an ethylene-ethyl acrylate copolymer (abbreviated to EEA. Jrex A3100, manufactured by Japan Polyolefins Co., Ltd.) and 30 parts by weight of a polypropylene (article number: PC600S, manufactured by SunAllomer Ltd.).

### (Example 6)

A multi-layer sheet having a three-layer structure was produced wherein the following three layers were laminated in order that the layers will be described: a layer, 25 µm in thickness, made of a polybutylene terephthalate resin (abbreviated to PBT. Novaduran 5040ZS (manufactured by Mitsubishi Engineering-Plastics Corp.); a layer, 100 µm in thickness, made of 90 parts by weight of a linear low-density polyethylene resin (Affinity PL1880, manufactured by Dow Chemicals Co.) and 10 parts by weight of the same polybutylene terephthalate resin (Novaduran 5040ZS (manufactured by Mitsubishi Engineering-Plastics Corp.); and a layer, 25 µm in thickness, made of the same polybutylene terephthalate resin (Novaduran 5040ZS (manufactured by Mitsubishi Engineering-Plastics Corp.).
Separately, an extruder was used to produce a 100-µm sheet made of 90 parts by weight of the same linear low-density polyethylene resin (Affinity PL1880, manufactured by Dow Chemicals Co.) and 10 parts by weight of the same polybutylene terephthalate resin (Novaduran 5040ZS (manufactured by Mitsubishi Engineering Plastics Corp.) as a sheet for evaluation.

### (Example 7)

A three-layer extruder was used to produce a multi-layer sheet having a three-layer structure wherein the following three layers were laminated in order that the layers will be described: a layer, 25 µm in thickness, made of the above-mentioned polybutylene terephthalate resin (Novaduran 5040ZS (manufactured by Mitsubishi Engineering Plastics Corp.) ; a layer, 100 µm in thickness, made of 90 parts by weight of the above-mentioned ethylene-ethyl acrylate copolymer (Jrex A3100, manufactured by Japan Polyolefins Co., Ltd.) and 10 parts by weight of the same polybutylene terephthalate resin (Novaduran 5040ZS (manufactured by Mitsubishi Engineering Plastics Corp.); and a layer, 25 µm in thickness, made of the same polybutylene terephthalate resin (Novaduran 5040ZS (manufactured by Mitsubishi Engineering Plastics Corp.). Separately, an extruder was used to produce a 100-µm sheet made of 90 parts by weight of the same ethylene-ethyl acrylate copolymer (Jrex A3100, manufactured by Japan Polyolefins Co., Ltd.) and 10 parts by weight of the same polybutylene terephthalate resin (Novaduran 5040ZS (manufactured by Mitsubishi Engineering Plastics Corp.) as a sheet for evaluation.

### (Example 8)

A three-layer extruder was used to produce a multi-layer sheet having a three-layer structure wherein the following three layers were laminated in order that the layers will be described: a layer, 25 µm in thickness, made of the above-mentioned polybutylene terephthalate resin (Novaduran 5040ZS (manufactured by Mitsubishi Engineering Plastics Corp.); a layer, 100 µm in thickness, made of 90 parts by weight of the above-mentioned ethylene-ethyl acrylate copolymer (Jrex A3100, manufactured by Japan Polyolefins Co. , Ltd.) and 10 parts by weight of a polyester resin (Hytrel 4047, manufactured by Du Pont-Toray Co., Ltd.); and a layer, 25 µm in thickness, made of the same polybutylene terephthalate resin (Novaduran 5040ZS (manufactured by Mitsubishi Engineering Plastics Corp.). Separately, an extruder was used to produce a 100-µm sheet made of 90 parts by weight of the same ethylene-ethyl acrylate copolymer (Jrex A3100, manufactured by Japan Polyolefins Co., Ltd.) and 10 parts by weight of the same polyester resin (Hytrel 4047, manufactured by Du Pont-Toray Co., Ltd.) as a sheet for evaluation.

### (Example 9)

A three-layer extruder was used to produce a multi-layer sheet having a three-layer structure wherein the following three layers were laminated in order that the layers will be described: a layer, 25 µm in thickness, made of the above-mentioned polybutylene terephthalate resin (Novaduran 5040ZS (manufactured by Mitsubishi Engineering Plastics Corp.) ; a layer, 100 µm in thickness, made of 90 parts by weight of a low density polyethylene (Petrocene 175R, manufactured by Tosoh Corp.) and 10 parts by weight of the same polybutylene terephthalate resin (Novaduran 5040ZS (manufactured by Mitsubishi Engineering Plastics Corp.) ; and a layer, 25 µm in thickness, made of the same polybutylene terephthalate resin (Novaduran 5040ZS (manufactured by Mitsubishi Engineering Plastics Corp.).
Separately, an extruder was used to produce a 100- µm sheet made of 90 parts by weight of the same low density polyethylene (Petrocene 175R, manufactured by Tosoh Corp.) and 10 parts by weight of the same polybutylene terephthalate resin (Novaduran 5040ZS (manufactured by Mitsubishi Engineering Plastics Corp.) as a sheet for evaluation.

### (Comparative Example 1)

A multi-layer sheet of Comparative Example 1 was produced in the same way as in Example 1 except that the material of the two outside layers was rendered a polypropylene (article number: PC600S, manufactured by SunAllomer Ltd.) instead of the Hytrel 2751.

### (Comparative Example 2)

A three-layer extruder was used to produce a multi-layer sheet having a three-layer structure wherein the following three layers were laminated in order that the layers will be described: a layer, 25 µm in thickness, made of the above-mentioned polybutylene terephthalate resin (Novaduran 5040ZS (manufactured by Mitsubishi Engineering Plastics Corp.); a layer, 100 µm in thickness, made of the above-mentioned linear low-density polyethylene resin (Affinity PL1880) manufactured by Dow Chemicals Co.; and a layer, 25 µm in thickness, made of the same polybutylene terephthalate resin (Novaduran 5040ZS (manufactured by Mitsubishi Engineering Plastics Corp.).
Separately, an extruder was used to produce a 100- µm sheet made of the same linear low-density polyethylene resin (Affinity PL1880) as a sheet for evaluation.

### (Comparative Example 3)

A three-layer extruder was used to produce a multi-layer sheet having a three-layer structure wherein the following three layers were laminated in order that the layers will be described: a layer, 25 µm in thickness, made of the above-mentioned polybutylene terephthalate resin (Novaduran 5040ZS (manufactured by Mitsubishi Engineering Plastics Corp.); a layer, 100 µm in thickness, made of the above-mentioned ethylene-ethyl acrylate copolymer (Jrex A3100, manufactured by Japan Polyolefins Co., Ltd.); and a layer, 25 µm in thickness, made of the same polybutylene terephthalate resin (Novaduran 5040ZS (manufactured by Mitsubishi Engineering Plastics Corp.).
Separately, an extruder was used to produce a 100- µm sheet made of the same ethylene-ethyl acrylate copolymer (Jrex A3100, manufactured by Japan Polyolefins Co., Ltd.) as a sheet for evaluation.

### (Evaluation)

About the multi-layer sheets and the sheets for evaluation yielded in Examples 1-9 and Comparative Examples 1-3, evaluations were made by the following methods. The results are shown in Tables 1-3.

### (1) Evaluation of the blocking force of each releasing layer

Two sheets of each kind of the multi-layer sheets yielded as described above were prepared, and their releasing layers were pressed and bonded to each other under a condition of 170°C and 3 MPa for 30 minutes, so as to measure the blocking force thereof by a method according to ASTM F1893.

### (2) Evaluation of the dynamic viscoelasticity of each following-up layer:

About each of the sheets for evaluation, an RMS-800 manufactured by Rheometric Co. or the like was used and a parallel plate of 25 mm diameter was used as a tool to measure the complex viscosity and the tan δ thereof at 170°C and 250°C under a condition of a frequency of 10 rad/second, a strain of 10%, a temperature of 120-270°C and a temperature-raising rate of 5°C/minute.

### (3) Evaluation of the structure of each following-up layer:

The sheets for evaluation were each frozen with liquid nitrogen, and then a cross section thereof was prepared with a microtome. The cross section was observed with a transmission electron microscope (manufactured by JEOL Ltd.).

### (4) Practicability evaluation:

A polyimide film (Kaptone, manufactured by Du Pont Co.) of 25 µm thickness was used as a base film to produce a copper-clad laminate wherein a copper foil of 35 µm thickness and 50 µm width was bonded onto the base film through an epoxy adhesive agent layer of 20 µm thickness. Separately, an epoxy adhesive agent having a flow starting temperature of 80°C was applied onto the same polyimide film (Kaptone, manufactured by Du Pont Co.)of 25 µm thickness, so as to have a thickness of 20 µm. In this way, a cover-lay film was produced.

A product wherein each of the multi-layer sheets, the copper-clad laminate, the cover-lay film, and the same multi-layer sheet were laminated in this order was called one set. Thirty two out of a plurality of the sets were put on a hot press. The 32 sets were subjected to hot-press molding under a condition of a press temperature of 170°C and a press pressure of 3 MPa for a press time of 60 minutes, and then the press pressure was cancelled. The multi-layer sheets were peeled therefrom so as to yield a flexible printed circuit board. In the production of this flexible printed circuit board, the releasability, the adhesive property, electrode stains of the produced flexible printed circuit board, the forcing-out of the following-up layer from the multi-layer sheets, and the adhesion thereof onto the press hot plate were evaluated with the naked eye and an optical microscope (power: 100 magnifications).

**[Table 1]**

| | Releasing Layer | Following-Up Layer | Layer Structure |
|---|---|---|---|
| Ex. 1 | Hytrel 2751 | EMMA(WH102) | 25/100/25 |
| Ex. 2 | Hytrel 2751 | EMMA(WH102) | 25/100/25 |
| Ex. 3 | Hytrel 2751 | EMMA(WH102) | 25/100/25 |
| Ex. 4 | Hytrel 2751 | LDPE(173R) | 25/100/25 |
| Ex. 5 | Hytrel 2751 | EEA(70)/PP(30) | 25/100/25 |
| Ex. 6 | PBT | PL1880(90)/PBT(10) | 25/100/25 |
| Ex. 7 | PBT | EEA(90)/PBT(10) | 25/100/25 |
| Ex. 8 | PBT | EEA(90)/ Hytrel (10) | 25/100/25 |
| Ex. 9 | PBT | LDPE(90)/PBT(10) | 25/100/25 |
| Comp. Ex. 1 | PP | EMMA (WH102) | 25/100/25 |
| Comp. Ex. 2 | PBT | PL1880 | 25/100/25 |
| Comp. Ex. 3 | PBT | EEA | 25/100/25 |

**[Table 2]**

| | Releasing Layer | | | | Following -Up Layer | | | | | | |
|---|---|---|---|---|---|---|---|---|---|---|---|
| | Surface Treatment | Blocking Force (N/cm) | Composition | Resin Melting Point(°C) | Composition | Resin Melting Point (°C) | Phase Structure | Complex Viscosity (Pa·s) | | tan *δ* | |
| | | | | | | | | 170°C | 250°C | 170°C | 250°C |
| Ex. 1 | None | 0.04 | Polar Group Contained | 220 | Polar Group Contained | 90 | - | 7000 | - | 0.65 | - |
| Ex. 2 | Heat Treatment | 0.015 | Polar Group Contained | 220 | Polar Group Contained | 90 | - | 7000 | - | 0.65 | - |
| Ex. 3 | Rubbing Treatment | 0.017 | Polar Group Contained | 220 | Polar Group Contained | 90 | - | 7000 | - | 0.65 | - |
| Ex. 4 | Heat Treatment | 0.015 | Polar Group Contained | 220 | Nonpolar | 110 | - | 7000 | - | 0.65 | - |
| Ex. 5 | Heat Treatment | 0.015 | Polar Group Contained | 220 | Polar Group Contained | 95 and 165 | A Clear Structure was Unable to be Observed | 6500 | - | 0.9 | - |
| Ex. 6 | None | 0.03 | Polar Group Contained | 224 | Polar Group Containing-Resin Blend | 100 and 224 | Sea-Island Structure | 7000 | 2300 | 0.85 | 1.90 |
| Ex. 7 | None | 0.03 | Polar Group Contained | 224 | Polar Group Contained | 104 and 224 | Sea-Island Structure | 6000 | 1800 | 0.88 | 1.85 |
| Ex. 8 | None | 0.03 | Polar Group Contained | 224 | Polar Group Contained | 104 and 190 | Sea-Island Structure | 5700 | 1800 | 0.95 | 2.00 |
| Ex. 9 | None | 0.03 | Polar Group Contained | 224 | Polar Group Containing-Resin Blend | 111 and 224 | | 7500 | 2800 | 0.65 | 1.10 |
| Comp. Ex. 1 | None | - | Nonpolar | 165 | Polar Group Contained | 90 | - | 7000 | - | 0.65 | - |
| Comp. Ex. 2 | None | 0.03 | Polar Group Contained | 224 | Polar Group Containing-Resin Blend | 100 | - | 6500 | 2200 | 1.70 | 2.20 |
| Comp. Ex. 3 | None | 0.03 | Polar Group Contained | 224 | Polar Group Contained | 104 | - | 3000 | 1300 | 1.50 | 2.10 |

**[Table 3]**

| | Practicability Evaluation | | | |
|---|---|---|---|---|
| | Releasability | Following-Up Property | Electrode Stains | Forcing-Out of the Following-Up Layer, and Adhesion Thereof onto the Hot Plate |
| Ex. 1 | Good | Very Good | None | None |
| Ex. 2 | Very Good | Very Good | None | None |
| Ex. 3 | Very Good | Very Good | None | None |
| Ex. 4 | Very Good | Good | None | None |
| Ex. 5 | Very Good | Very Good | None | None |
| Ex. 6 | Good | Good | None | None |
| Ex. 7 | Good | Good | None | None |
| Ex. 8 | Good | Good | None | The Layer was Somewhat Forced Out but did not Adhere to the Hot Plate |
| Ex. 9 | Good | Good | None | None |
| Comp. Ex. 1 | The Sheet was Melted and was Unpractical | | | |
| Comp. Ex. 2 | Good | Good | None | The Layer was Forced Out and Further the Layer Adhered to the Plate |
| Comp. Ex. 3 | Good | Good | None | The Layer was Forced Out and Further the Layer Adhered to the Plate |

## Claims

1. A multi-layer sheet, which comprises a following-up layer comprising a resin composition including mainly a first resin having a melting point, which is a melting peak temperature measured by DSC, in the range of 50 to 130°C and a second resin, wherein the first and the second resins are incompatible to each other and are made into a sea-island structure, and a releasing layer comprising a resin composition including mainly a resin being a crystalline aromatic polyester having a polar group in the main chain and having a melting point of 200°C or higher and laminated on the following-up layer, wherein when the two releasing layers of the multi-layer sheets are pressed and bonded onto each other under a condition of 170°C and 3 MPa for 30 minutes, the releasing layers exhibit a blocking force of 0.1 N/cm or less, the blocking force being measured in accordance with ASTM D1893.

2. The multi-layer sheet according to claim 1, wherein the second resin has a melting point higher than 130°C and not higher than 250°C, the melting point being melting peak temperature measured by DSC.

3. The multi-layer sheet according to claim 1 or 2, wherein the following-up layer has a complex viscosity of 1000 to 10000 Pa·s at 170°C and a tan δ of less than 1 at 170°C.

4. The multi-layer sheet according to any one of claims 1 to 3, wherein a second releasing layer is laminated on a face of the following-up layer which is opposite to the following-up layer face on which the releasing layer is laminated, the second releasing layer comprises a resin composition including mainly a resin having a melting point of 200°C or higher, and when the two releasing layers (the first and second releasing layers or the second releasing layers) are pressed and bonded onto each other under a condition of 170°C and 3 MPa for 30 minutes, the releasing layers exhibit a blocking force of 0.1 N/cm or less, the blocking force being measured in accordance with ASTM D1893.

5. The multi-layer sheet according to any one of claims 1 to 4, wherein the following-up layer has a complex viscosity of 100 to 5000 Pa·s at 250°C and a tan δ of 1.5 or more at 250°C.

6. The multi-layer sheet according to 1, wherein the melting point of the second resin which constitutes the islands in the sea-island structure is higher than that of the first resin which constitutes the sea therein.

7. The multi-layer sheet according to claim 6, wherein the melting point of the first resin which constitutes the sea is from 50 to 130°C.

8. The multi-layer sheet according to claim 6 or 7, wherein the melting point of the second resin which constitutes the islands is 130°C or higher.

9. The multi-layer sheet according to any one of claims 1 to 8, wherein the resin having the polar group in the main chain thereof further comprises at least one resin of a polymethylpentene and an α-olefin copolymer.

10. The multi-layer sheet according to any one of claims 1 to 9, wherein the crystalline aromatic polyester, as the resin having the polar group in the main chain thereof, comprises at least butylene terephthalate as a crystal component in the releasing layer.

11. The multi-layer sheet according to any one of claims 1 to 10, wherein the crystal melting heat quantity by DSC is 40 J/g or more.

12. The multi-layer sheet according to any one of claims 1 to 11, wherein when the two releasing layers of the multi-layer sheets are pressed and bonded onto each other under a condition of 170°C and 3 MPa for 30 minutes, the releasing layers exhibit a blocking force of 0.02 N/cm or less, the blocking force being measured in accordance with ASTM D 1893.

13. The multi-layer sheet according to any one of claims 1 to 12, wherein a halogen content of the releasing layer is 5% by weight or less.

14. A method for the manufacture of the multi-layer sheet according to any one of claims 1 to 13 comprising laminating the following-up layer and the releasing layer on each other.

15. The method of claim 14, wherein at least a surface of the releasing layer is subjected to heat treatment at a temperature which is not lower than a glass transition temperature of the resin having the polar group in the main chain thereof and not higher than the melting point thereof.

16. The method of claims 14 or 15, wherein a surface of the releasing layer is subjected to a rubbing treatment.

## Patentansprüche

1. Mehrlagige Folie, welche eine Nachfolgeschicht, umfassend eine Harzzusammensetzung, beinhaltend hauptsächlich ein erstes Harz mit einem Schmelzpunkt, der eine durch DSC gemessene Schmelz-Peaktemperatur im Bereich von 50 bis 130°C ist, und ein zweites Harz, wobei das erste und das zweite Harz zueinander inkompatibel sind und zu einer See-Insel-Struktur ausgebildet sind, und eine Trennschicht, umfassend eine Harzzusammensetzung, beinhaltend hauptsächlich ein Harz, das ein kristalliner aromatischer Polyester mit einer polaren Gruppe in der Hauptkette ist und einen Schmelzpunkt von 200°C oder höher aufweist, und auf der Nachfolgeschicht laminiert ist, umfasst, wobei, wenn die zwei Trennschichten der mehrlagigen Folien unter einer Bedingung von 170°C und 3 MPa während 30 Minuten gepresst und aufeinander gebunden werden, die Trennschichten eine Blockierkraft von 0,1 N/cm oder weniger zeigen, wobei die Blockierkraft gemäß ASTM D1893 gemessen wird.

2. Mehrlagige Folie nach Anspruch 1, wobei das zweite Harz einen Schmelzpunkt von höher als 130°C und nicht höher als 250°C besitzt, wobei der Schmelzpunkt die durch DSC gemessene Schmelz-Peaktemperatur ist.

3. Mehrlagige Folie nach Anspruch 1 oder 2, wobei die Nachfolgeschicht eine komplexe Viskosität von 1000 bis 10000 Pa·s bei 170°C und einen tan δ von weniger als 1 bei 170°C aufweist.

4. Mehrlagige Folie nach mindestens einem der Ansprüche 1 bis 3, wobei eine zweite Trennschicht auf einer Seite der Nachfolgeschicht laminiert ist, welche der Seite der Nachfolgeschicht, auf welcher die Trennschicht laminiert ist, gegenüberliegt, wobei die zweite Trennschicht eine Harzzusammensetzung umfasst, beinhaltend hauptsächlich ein Harz mit einem Schmelzpunkt von 200°C oder höher, und wenn die zwei Trennsichten (die erste und zweite Trennschicht oder die zweiten Trennschichten) unter einer Bedingung von 170°C und 3 MPa während 30 Minuten gepresst und aufeinander gebunden werden, die Trennschichten eine Blockierkraft von 0,1 N/cm oder weniger zeigen, wobei die Blockierkraft gemäß ASTM D 1893 gemessen wird.

5. Mehrlagige Folie nach mindestens einem der Ansprüche 1 bis 4, wobei die Nachfolgeschicht eine komplexe Viskosität von 100 bis 5000 Pa·s bei 250°C und einen tan δ von 1,5 oder mehr bei 250°C aufweist.

6. Mehrlagige Folie nach Anspruch 1, wobei der Schmelzpunkt des zweiten Harzes, das die Inseln in der See-Insel-Struktur bildet, höher ist als der des ersten Harzes, das darin den See bildet.

7. Mehrlagige Folie nach Anspruch 6, wobei der Schmelzpunkt des ersten Harzes, das den See bildet, 50 bis 130°C beträgt.

8. Mehrlagige Folie nach Anspruch 6 oder 7, wobei der Schmelzpunkt des zweiten Harzes, das die Inseln bildet, 130°C oder höher ist.

9. Mehrlagige Folie nach mindestens einem der Ansprüche 1 bis 8, wobei das Harz mit einer polaren Gruppe in dessen Hauptkette weiterhin mindestens ein Harz aus einem Polymethylpenten- und einem α-Olefin-Copolymer umfasst.

10. Mehrlagige Folie nach mindestens einem der Ansprüche 1 bis 9, wobei der kristalline aromatische Polyester als das Harz mit einer polaren Gruppe in dessen Hauptkette, mindestens Butylenterephthalat als eine Kristallkomponente in der Trennschicht umfasst.

11. Mehrlagige Folie nach mindestens einem der Ansprüche 1 bis 10, wobei die durch DSC gemessene Kristall-Schmelzwärmemenge 40 J/g oder mehr beträgt.

12. Mehrlagige Folie nach mindestens einem der Ansprüche 1 bis 11, wobei, wenn die zwei Trennschichten der mehrlagigen Folien unter einer Bedingung von 170°C und 3 MPa während 30 Minuten gepresst und aufeinander gebunden werden, die Trennschichten eine Blockierkraft von 0,02 N/cm oder weniger zeigen, wobei die Blockierkraft gemäß ASTM D1893 gemessen wird.

13. Mehrlagige Folie nach mindestens einem der Ansprüche 1 bis 12, wobei ein Halogengehalt der Trennschicht 5 Gew.-% oder weniger beträgt.

14. Verfahren zur Herstellung der mehrlagigen Folie gemäß mindestens einem der Ansprüche 1 bis 13, umfassend Laminieren der Nachfolgeschicht und der Trennschicht aufeinander.

15. Verfahren nach Anspruch 14, wobei mindestens eine Oberfläche der Trennschicht einer Wärmebehandlung bei einer Temperatur unterzogen wird, welche nicht niedriger ist als die Glasübergangstemperatur des Harzes mit der polaren Gruppe in dessen Hauptkette und nicht höher als der Schmelzpunkt hiervon.

16. Verfahren nach Anspruch 14 oder 15, wobei eine Oberfläche der Trennschicht einer Reibbehandlung unterzogen wird.

## Revendications

1. Feuille à plusieurs couches, qui comprend une couche suivante rapprochée faite d'une composition de résine comprenant à son tour une première résine ayant un point de fusion qui est une température de pic de fusion mesurée par DSC, dans la plage de 50 à 130 ° C et une seconde résine, la première et la seconde résine incompatibles l'une par rapport à l'autre et réalisées en une structure en îlots ; et une couche anti-adhérente comprenant une composition de résine constituée principalement de résine étant un polyester aromatique cristallin ayant un groupe polaire dans la chaîne principale et ayant un point de fusion de 200 ° C ou plus et stratifiée sur la couche suivante rapprochée de telle sorte que lorsque les deux couches de libération des feuilles multicouches sont pressées et liées l'une à l'autre dans une condition de 170 ° C et 3 MPa pendant 30 minutes, les couches anti-adhérentes présentent une force de blocage de 0.1N/cm ou moins, la force de blocage étant mesurée conformément à la norme ASTM D1893.

2. Feuille multicouche selon la revendication 1, où la seconde résine a un point de fusion supérieur à 130 ° C et non supérieur à 250 ° C, le point de fusion étant la température de pic de fusion mesurée par DSC.

3. Feuille multicouche selon la revendication 1 ou 2, où la couche suivante rapprochée a une viscosité complexe de 1 000 à 10 000 Pa.s à 170 ° C et une tan 6 de moins de 1 à 170 ° C.

4. Feuille multicouche selon l'une quelconque des revendications entre 1 et 3, où une seconde couche anti-adhérente est stratifiée sur une face de la couche suivante rapprochée en place qui est opposée à la face de la couche suivante rapproché sur laquelle la couche anti-adhérente est stratifiée, la deuxième couche anti-adhérente comprend une composition de résine faite principalement d'une résine ayant un point de fusion de 200 ° C ou plus, et lorsque les deux couches anti-adhérentes (la première et la deuxième couche anti-adhérente ou les deuxièmes couches anti-adhérentes) sont pressées et liées l'une à l'autre sous un état de 170 ° C et 3 MPa pendant 30 minutes, les couches anti-adhérentes présentent une force de blocage de 0.1N/cm ou moins, la force de blocage étant mesurée conformément à la norme ASTM D1893.

5. Feuille multicouche selon l'une quelconque des revendications entre 1 à 4, où la couche suivante rapprochée a une viscosité complexe de 100 à 5 000 Pa.s à 250 ° C et un tan δ de 1,5 ou plus à 250 ° C.

6. Feuille multicouche selon 1, où le point de fusion de la seconde résine qui constitue des îles dans la structure en îlots est supérieur à celui de la première résine qui constitue la mer à cet égard.

7. Feuille multicouche selon la revendication 6, où le point de fusion de la première résine qui constitue la mer varie de 50 à 130 ° C.

8. Feuille multicouche selon la revendication 6 ou 7, où le point de fusion de la seconde résine qui constitue des îlots est de 130 ° C ou plus.

9. Feuille multicouche selon l'une quelconque des revendications 1 à 8, où la résine ayant le groupe polaire dans la chaîne principale de celle-ci comprend en outre au moins une résine d'un polyméthylpentène et d'un copolymère a-oléfine.

10. Feuille multicouche selon l'une quelconque des revendications entre 1 à 9, où le polyester aromatique cristallin, la résine ayant le groupe polaire dans la chaîne principale de celui-ci, comprend au moins le téréphtalate de butylène en tant que composant de cristal dans la couche anti-adhérente.

11. Feuille multicouche selon l'une quelconque des revendications entre 1 et 10, où la quantité de chaleur de fusion par DSC est de 40 J / g ou plus.

12. Feuille multicouche selon l'une quelconque des revendications entre 1 et 11, où, lorsque les deux couches anti-adhérentes des feuilles multicouches sont pressées et liées l'une à l'autre dans une condition de 170 ° C et 3 MPa pendant 30 minutes, les couches anti-adhérentes présentent une force de blocage de 0,02 N / cm ou moins, la force de blocage étant mesurée conformément à la norme ASTM D1893.

13. Feuille multicouche selon l'une quelconque des revendications entre 1 et 12, où une teneur en halogène de la couche anti-adhérente est de 5% en poids ou moins.

14. Procédé de fabrication de la feuille multicouche selon l'une quelconque des revendications entre 1 et 13, comprenant la stratification de la couche suivante rapprochée et de la couche anti-adhérente l'une sur l'autre.

15. Procédé selon la revendication 14, lors duquel au moins une surface de la couche anti-adhérente est soumise à un traitement thermique à une température qui n'est pas inférieure à une température de transition vitreuse de la résine ayant le groupe polaire dans la chaîne principale de celui-ci et non supérieure à son point de fusion.

16. Procédé selon la revendication 14 ou 15, lors duquel une surface de la couche anti-adhérente est soumise à un traitement de frottement.
